# EUROPEAN PATENT SPECIFICATION

(11) **EP 0 516 455 B1**
(45) Date of publication and mention of the grant of the patent: **04.03.1998**
(21) Application number: 92304919.1
(22) Date of filing: 29.05.1992
(51) Int. Cl.: G06F 13/40, H05K 7/14

(54) **Electrical, intrinsically-safe interface devices**
Elektrische, eigensichere Schnittstelleneinrichtungen
Dispositifs d'interface électrique à securité intrinsèque

(30) Priority: 29.05.1991 GB 9111534
(43) Date of publication of application: 02.12.1992
(73) Proprietor: MEASUREMENT TECHNOLOGY LIMITED, Luton Bedfordshire LU1 3JJ (GB)
(72) Inventor: Lytollis, Barry James, St. Albans, Hertfordshire AL3 5HW (GB)
(74) Representative: W.P. THOMPSON & CO.

(56) References cited:
- EP-A- 0 323 579
- DE-A- 3 418 844
- DE-A- 3 933 099
- US-A- 4 099 216
- US-A- 4 777 375
- BBC-NACHRICHTEN vol. 53, no. 1/2, January 1971, pages 37 - 45; VON DIRK-HOLGER KRÄMER ET AL.: 'NEUZEITLICHER EXPLOSIONSSCHUTZ DURCH SICHERHEITSBARRIEREN'

## Description

This invention as it is defined in the appended claims relates to electrical intrinsically-safe interface devices, and particularly to electrical isolators. It is particularly concerned with intrinsically-safe galvanic isolators which are used as barriers between control equipment which is in non-hazardous areas and process equipment which is situated in areas where combustible gases may be present. An intrinsically-safe system is one which provides protection against explosion in an environment containing gases or vapours by limiting the electrical power so that the energy of any spark or hot surface is insufficient to cause ignition.

A box-shaped electrical assembly is known from DE-A-3418844 in which modules are physically mounted on a rail and are electrically connected to a power supply. Each module includes a plug unit to which the power supply is connected. The plug unit is pivotable into and out of contact with a plug strip which is mechanically and electrically connected to a circuit board enclosed within the module.

US-A-4099216 describes an intrinsic safety barrier which features a fuseless, encapsulated module.

Known isolators for intrinsically-safe systems have the wiring from both the hazardous area and the non-hazardous area routed via the backplane of the isolator. In other words, the wiring for both areas is connected to the backplane, and the isolator itself is plugged into the backplane. Because the backplane carries terminals for wiring from a hazardous area, the backplane requires certification, in addition to the isolator having to be certified.

It is an object of the present invention to provide an intrinsically-safe interface device in which the backplane carries no terminals for wiring from the hazardous area and therefore the backplane does not require certification.

It is also an object of the invention to provide an interface device in which the backplane can be kept small, thereby saving space, and in which the number of terminations a circuit has to pass through is reduced.

In accordance with the present invention there is provided an electrical, intrinsically-safe interface device comprising:
a mounting board;
at least one electrical module physically connected to the mounting board; and
first electrical connector means forming part of said module or modules to permit connection of the module or modules to external wiring;
characterised in that the or each module is an interface unit to be connected between a hazardous area and a non-hazardous area;
said first electrical connector means makes connection to wiring from the hazardous area;
the or each module is also electrically connected to said mounting board;
and second electrical connector means are provided to connect the or each module via the mounting board to wiring to/from the non-hazardous area.

Preferably, the first connector means comprises a socket in the or each interface unit adapted to receive a plug connected to the wiring from the hazardous area.

In a preferred embodiment, where the interface unit is an isolator module, the plug and socket means is provided at the top face of the isolator module and a power connection is provided by connector means at the opposite, bottom face of the module.

In order that the invention may be more fully understood, a presently preferred embodiment of isolator will now be described by way of example and with reference to the accompanying drawings, in which:
Fig. 1 shows the complete isolator and the method of connecting wiring thereto;

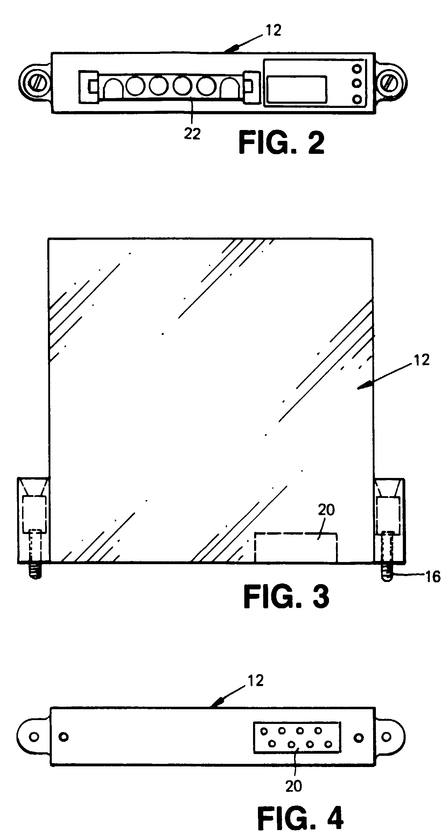

Fig. 2 is a top plane view of one of the modules of the isolator in Fig. 1;
Fig. 3 is a side view of the isolator module of Fig. 2; and
Fig. 4 is a bottom plan view of the isolator module of Fig. 2.

As shown in the drawings, the isolator, which is indicated generally at 10, is composed of one or a plurality of isolator modules 12 arranged in side-by-side relationship. The individual modules 12 are mounted on a board 14 which constitutes the backplane of the isolator by respective screws 16. The bottom face of each module, i.e. that in contact with the backplane 14, is provided with a safe/power connector 20. The connector 20 is recessed into the module and mates with pins projecting from the board 14. The connector 20 connects the module both to a power supply and to wiring connecting the module to control equipment, for example, which is located in a non-hazardous area. The top face of each isolator module 12 is provided with connector means in the form of a recessed socket 22 which lies wholly below the surface of the module 12.

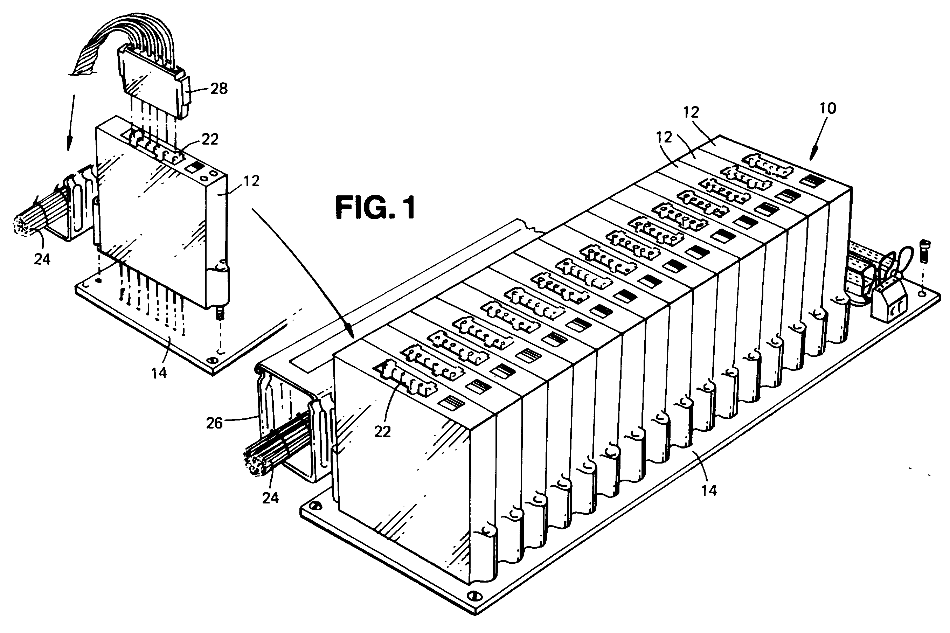

Electrical wiring 24 from a hazardous area (not shown) where combustible gases for example may be present runs in a conduit 26 behind the isolator 10 and connections between that wiring and the isolator modules 12 is effected by providing the relevant parts of the wiring with plugs 28 which are arranged to be received directly in the sockets 22. This is shown most clearly in Fig. 1. It is to be understood that alternative designs of plug and socket can be envisaged and fall within the scope of the present application.

Instead of plug and socket connections on the modules one could have alternative connection means, such as terminal connectors for example. The important feature is that the connections, of whatever type, to the hazardous area are on the isolator unit itself and not on the backplane 14 into which the isolator unit is plugged. This means that the backplane 14 can be kept small, the backplane does not have to be certified, and it reduces the number of terminations a circuit has to pass through.

Although the invention has been described above in relation to an isolator, the concept of the invention can be applied to other intrinsically-safe interface devices, for example safety barriers and especially shunt-diode safety barriers. In other words, the wiring from the hazardous area is directly connected to the safety barrier itself and not to a mounting plate or the like on which the safety barrier is carried.

Furthermore, it is not necessary that the connection point on the isolator to the hazardous area wiring is on the top surface of the isolator, although that is preferred. It could be located elsewhere on the isolator.

## Claims

1. An electrical, intrinsically-safe interface device comprising:
a mounting board (14);
at least one electrical module (12) physically connected to the mounting board; and,
first electrical connector means (22) forming part of said module or modules (12) to permit connection of the module or modules to external wiring (24);
characterised in that the or each module (12) is an interface unit to be connected between a hazardous area and a non-hazardous area;
said first electrical connector means (22) makes connection to wiring (24) from the hazardous area;
the or each module (12) is also electrically connected to said mounting board (14);
and second electrical connector means (20) are provided to connect the or each module (12) via the mounting board (14) to wiring to/from the non-hazardous area.

2. An interface device according to claim 1, characterised in that the first connector means comprises a socket (22) in the or each interface unit (12) adapted to receive a plug (28) connected to the wiring (24) from the hazardous area.

3. An interface device according to claim 2, characterised in that the socket or sockets (22) are recessed below the surface of the interface unit or units (12).

4. An interface device according to any preceding claim, characterised in that the or each interface unit (12) is of block form with a first surface in contact with the mounting board (14) and provided with means to connect with the second connector means (20), and with a second surface oppositely disposed to said first surface and provided with said first connector means (22).

5. An interface device according to any preceding claim, characterised in that the mounting board comprises a plate (14) to one surface of which the interface unit or units is/are secured (16).

6. An interface device according to any preceding claim, characterised by conduit means (26) for wiring (24) from the hazardous area extending past the interface unit or units (12).

7. An interface device according to any preceding claim, characterised in that said at least one interface unit (12) comprises one or more isolator units.

8. An interface device according to any of claims 1 to 6, characterised in that said at least one interface unit (12) comprises one or more shunt-diode safety barriers.

## Patentansprüche

1. Elektrische eigensichere Schnittstelleneinrichtung, umfassend:
eine Montageplatte (14);
wenigstens ein physikalisch mit der Montageplatte verbundenes elektrisches Modul (12); und
ein erstes elektrisches Anschlußmittel (22), das einen Teil des Moduls oder der Module (12) bildet und eine Verbindung des Moduls oder der Module mit einer externen Verdrahtung (24) gestatten soll;
dadurch gekennzeichnet, daß das oder jedes Modul (12) eine Schnittstelleneinheit ist, die zwischen einem explosionsgefährdeten Bereich und einem nicht-explosionsgefährdeten Bereich angeschlossen werden soll;
das erste elektrische Anschlußmittel (22) eine Verbindung mit der Verdrahtung (24) aus dem explosionsgefährdeten Bereich;
das oder jedes Modul (12) auch mit der Montageplatte (14) elektrisch verbunden ist;
und zweite elektrische Anschlußmittel (20) vorgesehen sind, um das oder jedes Modul (12) über die Montageplatte (14) mit einer Verdrahtung zu/aus dem nicht-explosionsgefährdeten Bereich zu verbinden.

2. Schnittstelleneinrichtung nach Anspruch 1, dadurch gekennzeichnet, daß das erste Anschlußmittel eine Buchse 22 in der oder jeder Schnittstelleneinheit (12) umfaßt, die einen mit der Verdrahtung (24) aus dem explosionsgefährdeten Bereich verbundenen Stecker (28) aufnehmen kann.

3. Schnittstelleneinrichtung nach Anspruch 2, dadurch gekennzeichnet, daß die Buchse oder Buchsen (22) unterhalb der Fläche der Schnittstelleneinheit oder -einheiten (12) ausgespart ist.

4. Schnittstelleneinrichtung nach einem beliebigen vorhergehenden Anspruch, dadurch gekennzeichnet, daß das oder jede Schnittstelleneinheit (12) eine Blockform mit einer ersten Fläche in Kontakt mit der Montageplatte (14) aufweist und mit einem Mittel zur Verbindung mit dem zweiten Anschlußmittel (20) und mit einer zweiten Fläche versehen ist, die entgegengesetzt zu der ersten Fläche angeordnet ist und mit dem ersten Anschlußmittel (22) versehen ist.

5. Schnittstelleneinrichtung nach einem beliebigen vorhergehenden Anspruch, dadurch gekennzeichnet, daß die Montageplatte eine Platte (14) umfaßt, an deren einer Fläche die Schnittstelleneinheit (16) oder -einheiten befestigt ist/sind.

6. Schnittstelleneinrichtung nach einem beliebigen vorhergehenden Anspruch, gekennzeichnet durch ein Kanalmittel (26) für die Verdrahtung (24) aus dem explosionsgefährdeten Bereich, das sich an der Schnittstelleneinheit oder -einheiten (12) vorbei erstreckt.

7. Schnittstelleneinheit nach einem beliebigen vorhergehenden Anspruch, dadurch gekennzeichnet, daß die wenigstens eine Schnittstelleneinheit (12) eine oder mehrere Isolatoreinheiten umfaßt.

8. Schnittstelleneinheit nach einem beliebigen der Ansprüche 1 bis 6, dadurch gekennzeichnet, daß die wenigstens eine Schnittstelleneinheit (12) eine oder mehrere Shuntdioden-Sicherheitsbarrieren umfaßt.

## Revendications

1. Dispositif d'interface électrique à sécurité intrinsèque comprenant:
une plaque de montage (14);
au moins un module électrique (12) connecté physiquement à la plaque de montage; et
un premier moyen formant connecteur électrique (22) constituant une partie dudit module ou desdits modules (12) afin de permettre la connexion du module ou des modules avec le câblage externe (24);
caractérisé en ce que le ou chaque module (12) est une unité d'interface devant être connectée entre une zone dangereuse et une zone non dangereuse;
ledit premier moyen formant connecteur électrique (22) réalise une connexion avec le câblage (24) provenant de la zone dangereuse;
le ou chaque module (12) est aussi connecté électriquement à ladite plaque de montage (14);
et en ce que des seconds moyens formant connecteur électrique (20) sont prévus afin de connecter le ou chaque module (12) par l'intermédiaire de la plaque de montage (14) avec le câblage allant vers la zone non dangereuse ou provenant de celle-ci.

2. Dispositif d'interface selon la revendication 1, caractérisé en ce que le premier moyen formant connecteur comprend une embase (22) dans l'unité ou chaque unité d'interface (12) qui est adaptée pour recevoir une fiche (28) connectée au câblage (24) provenant de la zone dangereuse.

3. Dispositif d'interface selon la revendication 2, caractérisé en ce que l'embase ou les embases (22) sont encastrées au-dessous de la surface de l'unité ou des unités d'interface (12).

4. Dispositif d'interface selon l'une quelconque des revendications précédentes, caractérisé en ce que l'unité ou chaque unité d'interface (12) est sous forme d'un bloc dont une première surface est en contact avec la plaque de montage (14) et comporte un moyen permettant de la connecter avec le second moyen formant connecteur (20), et dont une seconde surface est disposée à l'opposé de ladite première surface et comporte ledit premier moyen formant connecteur (22).

5. Dispositif d'interface selon l'une quelconque des revendications précédentes, caractérisé en ce que la plaque de montage comprend une plaque (14) sur une surface de laquelle l'unité ou les unités d'interface est (sont) fixée(s) (16).

6. Dispositif d'interface selon l'une quelconque des revendications précédentes, caractérisé par un moyen formant conduit (26) pour le câblage (24) provenant de la zone dangereuse s'étendant vers l'unité ou les unités d'interface (12).

7. Dispositif d'interface selon l'une quelconque des revendications précédentes, caractérisé en ce que ladite au moins une unité d'interface (12) comprend une ou plusieurs unités d'isolation.

8. Dispositif d'interface selon l'une quelconque des revendications 1 à 6, caractérisé en ce que ladite au moins une unité d'interface (12) comprend une ou plusieurs barrières de sécurité à diodes de dérivation.
